(19) **Europäisches Patentamt / European Patent Office / Office européen des brevets**

(11) **EP 2 586 166 B1**

(12) **FASCICULE DE BREVET EUROPEEN**

(45) Date de publication et mention de la délivrance du brevet:
**30.03.2016 Bulletin 2016/13**

(51) Int Cl.:
**H04L 27/20** (2006.01)   **G06K 19/07** (2006.01)

(21) Numéro de dépôt: **11727201.3**

(86) Numéro de dépôt international:
**PCT/EP2011/060659**

(22) Date de dépôt: **24.06.2011**

(87) Numéro de publication internationale:
**WO 2011/161257 (29.12.2011 Gazette 2011/52)**

(54) **PROCEDE DE MODULATION DE PHASE D'UN SIGNAL DE PORTEUSE D'UN ÉMETTEUR VERS UN TRANSPONDEUR SANS CONTACT ET DISPOSITIF POUR SA MISE EN OEUVRE**

PHASENMODULATIONSVERFAHREN EINES TRÄGERSIGNALS VON EINEM SENDER ZU EINEM KONTAKTLOSEN TRANSPONDER UND DESSEN IMPLEMENTIERUNGSEINRICHTUNG

METHOD FOR PHASE-MODULATING A CARRIER SIGNAL FROM A TRANSMITTER TO A CONTACTLESS TRANSPONDER AND IMPLEMENTING APPARATUS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.06.2010 FR 1055100**

(43) Date de publication de la demande:
**01.05.2013 Bulletin 2013/18**

(73) Titulaire: **Commissariat à l'Énergie Atomique et aux Énergies Alternatives 75015 Paris (FR)**

(72) Inventeurs:
• **REVERDY, Jacques**
  **F-38920 Crolles (FR)**

• **CROCHON, Elisabeth**
  **F-38320 Poisat (FR)**
• **DEHMAS, François**
  **F-38450 Vif (FR)**
• **PEBAY-PEYROULA, Florian**
  **F-38250 Saint-nizier-du-moucherot (FR)**

(74) Mandataire: **Croonenbroek, Thomas Jakob et al Innovincia 310 avenue Berthelot 69008 Lyon (FR)**

(56) Documents cités:
**WO-A2-97/41671        FR-A1- 2 917 557
US-A1- 2003 045 970**

**EP 2 586 166 B1**

**Description**

La présente invention concerne de façon générale la technique de modulation de phase d'un signal de porteuse dans le cadre d'échanges de données entre un lecteur ou station de base fixe et un transpondeur sans contact (carte, étiquette) placé dans le champ électromagnétique émis par le lecteur.

Plus précisément, l'invention concerne un procédé de modulation de phase d'un signal de porteuse d'un émetteur vers un transpondeur sans contact et un dispositif pour la mise en oeuvre du procédé.

Les systèmes électroniques radiofréquences pour l'identification (RFID pour « Radio Frequency IDentification » en anglais) trouvent des applications de plus en plus répandues.

En effet, ces systèmes sont déjà aujourd'hui largement utilisés pour identifier, localiser ou suivre des objets, des animaux et des personnes (cartes d'accès ; péage ; passeport électronique etc ).

Il s'agit en général d'un lecteur (« reader » en anglais) et d'un transpondeur intégré par exemple dans un support tel qu'une étiquette ou une carte (« tag » ou « card » en anglais). Dans la présente invention, on se réfère aussi bien aux transpondeurs téléalimentés, c'est-à-dire des transpondeurs ne disposant pas d'une source d'énergie propre pour transmettre des données que des transpondeurs disposant d'une source d'énergie propre, mais qui, en cas de défaillance de cette dernière ou pour certaines applications peuvent fonctionner, par exemple en mode dégradé, comme un transpondeur téléalimenté.

Le lecteur, considéré comme une station de base, génère une onde porteuse (champ magnétique alternatif de courte portée) qui sert à alimenter les cartes sans contact à proximité de l'antenne du lecteur. On parle alors de téléalimentation. De plus, cette onde porteuse fournit à la carte une horloge pour le fonctionnement de ses différents blocs. Enfin, elle sert de support pour les communications lecteur - carte et carte - lecteur.

On distingue dans l'échange des informations entre la station de base et le transpondeur la voie du lecteur vers la carte (la station de base a une fonction d'émetteur) et la voie de la carte vers le lecteur (la station de base a une fonction de récepteur).

Cet échange est soumis aux contraintes / prescriptions formulées par exemple dans la norme ISO14443 qui définit, entre autre, le type de modulation et de codage ainsi que le débit des transactions entre un lecteur et une carte sans contact. Ce débit est actuellement compris entre 106 et 848 kb/s.

Des propositions sont actuellement formulées pour étendre ce débit au-delà du Mb/s.

Pour être acceptées, ces extensions doivent être le plus compatible possible avec la norme actuelle. En effet, les industriels souhaitent un minimum de modifications du parc de lecteurs déjà installé.

Une autre contrainte concerne les émissions de champs magnétiques qui doivent respecter des recommandations européennes ERC-70-03 et/ou ETS 300-330.

Etat de la technique

Les transpondeurs sans contact répondant à la norme ISO 14443 sont très souvent télé-alimentés, c'est-à-dire qu'ils puisent leur énergie dans le champ magnétique généré par le lecteur. On rappelle que ce mode de fonctionnement n'est pas obligatoire mais l'émetteur (lecteur) ISO 14443 se doit de fournir un niveau de champ compris entre 1,5 et 7,5 A/m pour pouvoir assurer la téléalimentation des cartes.

Ce champ sert de canal de communication : il est le support pour transférer des informations entre le lecteur et la carte (ce sens est appelé voie aller), et entre la carte et le lecteur (voie retour).

Le champ magnétique est généralement créé par un courant RF, à 13,56MHz, circulant dans une antenne constituée d'une ou plusieurs boucles. Cette antenne peut être électriquement modélisée sous la forme d'un circuit résonnant de type R, L, C caractérisé par une fréquence centrale $f_c$, un coefficient de qualité Q et présentant une bande passante BP limitée.

$$f_c = 1/(2\pi \sqrt{LC}), \quad Q = (L\,2\,\pi\,f_c)/R \quad et \quad BP = f_c/Q$$

Pour optimiser l'utilisation de la puissance fournie par le lecteur, il est souhaitable de diminuer les pertes dans l'antenne en minimisant la résistance R. Dans ce cas, le coefficient de qualité Q est certes élevé, mais a pour effet de restreindre alors la bande passante du canal.

Pour les débits actuels de la norme ISO 14443, ceci n'est pas gênant.

Toutefois, si on souhaite augmenter les débits de transmission, on est contraint d'élargir la bande passante du canal et donc de diminuer le coefficient de qualité de l'antenne d'émission ce qui diminue l'alimentation du transpondeur.

En très haut débit, le choix de la bande passante du canal de transmission résulte donc d'un compromis entre

2

télé-alimentation et débit de transmission.

Une première solution pour augmenter les débits pourrait consister à diminuer la durée d'un bit en gardant les types de modulation et de codage actuellement décrits dans la norme ISO 14443, ce qui est reproduit dans la table qui suit :

| Délit | Durée bit | $BP_{min}$ | $Q_{max}$ |
|---|---|---|---|
| 106 kb/s | 9.43 $\mu$s | 212 kHz | 64 |
| 848 kb/s | 1.18 $\mu$s | 1.7 MHz | 8 |
| 1.7 Mb/s | 590 ns | 3.4 MHz | 4 |
| 6.78 Mb/s | 147 ns | 13.56 MHz | 1 |

On constate que le coefficient de qualité devient rapidement trop faible pour pouvoir envisager une téléalimentation compatible avec la puissance disponible sur les lecteurs actuels.

Pour augmenter le débit binaire sans trop augmenter la bande passante, il a été introduit la notion de modulation multi niveaux. Chaque niveau correspond à un symbole.

Dans cette approche, un symbole peut coder plusieurs bits et le débit binaire est alors lié au nombre de bits par symbole et à la durée du symbole. C'est cette dernière qui définit la bande passante nécessaire au signal et elle ne varie pas en fonction du nombre de niveaux.

$$\text{Débit binaire} = \log_2 (\text{nombre de symbole}) / \text{Durée symbole}.$$

Par exemple, si on dispose de 4 états et donc 4 symboles, on peut coder 2 bits par symbole de 8*Tc, le débit sera alors de 3,4 Mb/s, en supposant une porteuse à 13.56MHz.

Un autre problème lié aux cartes sans contact est la distance de fonctionnement généralement comprise entre 0 et 5 cm, ce qui implique une variation du coefficient de couplage k entre les antennes, accompagnée d'une variation de la bande passante du canal.

Il s'en suit une très grande dynamique d'amplitude du champ qui complique singulièrement la démodulation d'amplitude coté carte sans contact et, a fortiori, la démodulation multi-niveaux d'amplitude pour pouvoir coder plusieurs bits par symbole qui serait la continuité la plus logique avec la norme ISO14443.

C'est pourquoi il est envisagé d'orienter la modulation du champ magnétique de la station de base vers une modulation par saut de phase (PSK pour phase shift keying en anglais) utilisant différents états de phases de la porteuse.

Cette modulation proposée présente tout de même quelques inconvénients :

En effet, la modulation de phase induit indirectement des modulations d'amplitudes parasites au changement de symboles liées à la bande passante du canal. Ces modulations d'amplitude peuvent dégrader les capacités de discrimination du démodulateur dans la carte sans contact. Elles peuvent aller jusqu'à provoquer une perte d'horloge sur la carte sans contact ou une perte de télé-alimentation.

On rappelle que pour les transpondeurs téléalimentés, cela équivaut à une perte du canal de transmission, nécessitant donc le rétablissement de celui-ci ce qui allonge considérablement le temps de communication. A l'extrême, l'information ne peut plus être transmise et il y a échec de communication entre l'émetteur et le transpondeur.

On doit également remarquer que la modulation de phase étale le spectre d'émission avec de très fortes remontées des lobes latéraux prouvant conduire à des situations ne respectant pas la recommandation ERC 70-03, norme d'émission radio.

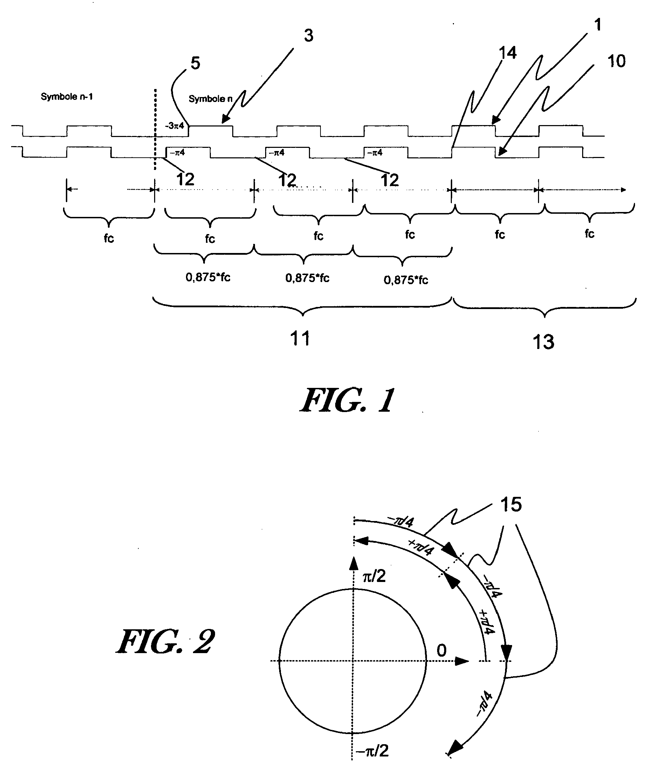

La figure 1 est un diagramme chronologique montrant à titre d'exemple la succession de niveaux pour deux symboles n-1 et n de longueur égale à $8*T_c$ ($T_c = 1/f_c$, où $f_c$ est la fréquence de la porteuse, par exemple de 13,56 MHz) dont la différence de phase entre les deux est de $3\pi/4$. Pour des raisons de simplification, seuls un cycle du symbole n-1 et cinq cycles du symbole n sont représentés.

Dans la partie haute référencée par la flèche 1 est représentée la transition selon l'état de la technique.

On constate qu'à la transition du symbole n-1 vers le symbole n, le niveau bas 3 est rallongé afin que le premier front montant 5 du symbole n soit directement déphasé de $-3\pi/4$ par rapport aux fronts du symbole précédent.

Ce sont donc ces sauts de phases importants qui posent problème pour la téléalimentation, pour la récupération de l'horloge et pour respecter les recommandations européennes ERC-70-03 et/ou ETS 300-330. Dans le document WO9741671, les sauts de phase sont seulement appliqués en début d'un symbole.

La présente invention vise à proposer un procédé de modulation de phase optimisé permettant de pallier au moins partiellement les inconvénients précités.

A cet effet, la présente invention propose un procédé de modulation de phase d'un signal de porteuse d'un émetteur vers un transpondeur sans contact selon la revendication 1.

Ce procédé peut de plus présenter seul ou en combinaison les caractéristiques suivantes :

- le seuil de saut de phase entre deux symboles consécutifs est de $\pi/4$,
- une portion de saut de phase est inférieure ou égale à $\pi/4$,
- les portions de saut de phase sont toutes de même valeur,
- les portions de saut de phase sont appliquées successivement sur les premières cycles de porteuse du symbole à transmettre,
- les portions de saut de phase sont appliquées sur les fronts montants du symbole à transmettre,
- on étale le saut de phase de manière continue, le signal et sa dérivé, sur la première partie du temps de symbole,
- le temps d'un symbole est égal à quatre ou huit cycles de porteuse,
- la première partie du temps de symbole, possède une durée inférieure ou égale à 75% du temps de symbole,
- le saut maximal de phase entre deux symboles consécutifs est strictement inférieur à $\pi$.

L'invention a également pour objet un dispositif de modulation de phase d'un signal de porteuse d'un émetteur vers un transpondeur sans contact selon la revendication 6.

Ce dispositif peut de plus présenter seul ou en combinaison les caractéristiques suivantes :

- le seuil de saut de phase entre deux symboles consécutifs est de $\pi\backslash4$,
- une portion de saut de phase est inférieure ou égale à $\pi/4$,
- les portions de saut de phase sont toutes de même valeur,
- lesdits moyens de codage de données sont configurés de manière à appliquer les portions de saut de phase successivement sur les premières cycles de porteuse du symbole à transmettre,
- lesdits moyens de codage de données sont configurés de manière à appliquer les portions de saut de phase sur les fronts montants du symbole à transmettre,
- lesdits moyens de codage de données comprennent des cellules d'application d'une portion d'un saut de phase à un signal de porteuse, de manière à couvrir l'ensemble de la gamme des états de phase, un multiplexeur recevant en entrée les signaux de porteuse et les signaux de porteuses déphasées ainsi que les données à coder et une unité de contrôle de multiplexage commandant le multiplexeur,
- lesdits moyens de codage de données sont configurés de manière à étaler le saut de phase de manière continue, signal et sa dérivé, sur la première partie du temps de symbole,
- lesdits moyens de codage de données comprennent un module de glissement de phase par variation de la fréquence de porteuse pendant la première partie du temps de symbole,
- le temps d'un symbole est égale à quatre ou huit cycles de porteuse,
- la première partie du temps de symbole, possède une durée inférieure ou égale à 75% du temps de symbole,
- le saut total maximal de phase entre deux symboles consécutifs est strictement inférieur à $\pi$.

D'autres avantages et caractéristiques apparaîtront à la lecture de la description de l'invention, ainsi que des figures suivantes sur lesquelles :

- la figure 1 est un diagramme chronologique montrant d'une part la transition entre deux symboles selon l'état de la technique et d'autre part la transition entre deux symboles selon le procédé de l'invention,
- la figure 2 est un diagramme de constellation d'états de phase pour un procédé selon l'invention,
- la figure 3 montre le spectre théorique d'émission électromagnétique induit par des sauts de phase,
- la figure 4, montre un schéma simplifié d'un dispositif de modulation de phase pour la mise en oeuvre du procédé selon un premier mode de réalisation,
- la figure 5 montre un schéma simplifié d'une variante de dispositif de modulation de phase,
- la figure 6 montre un schéma simplifié d'un dispositif de modulation de phase selon un second mode de réalisation, et
- la figure 7 est un diagramme chronologique permettant d'expliquer le fonctionnement du dispositif de la figure 6.

Sur toutes les figures, les éléments identiques portent les mêmes numéros de référence.

Dans ce qui suit, le terme « symbole » signifie un élément d'un alphabet de codage de données. Un symbole peut par exemple être un ensemble de 3 bits, tel que 011.

On décrira par la suite un procédé de modulation de phase d'un signal de porteuse d'un émetteur vers un transpondeur sans contact, dans lequel, pour avoir un débit de données suffisant et élevé, on code des données sous forme de symboles consécutifs ayant un nombre prédéfini de cycles de porteuse.

Le procédé de modulation de phase comprend au moins quatre états de phase, notamment quatre ou huit états de phase.

Dans le présent cas, l'émetteur est une station de base, par exemple un lecteur de cartes sans contact.

En ce qui concerne le transpondeur sans contact, il peut s'agir aussi bien de transpondeurs téléalimentés, que de transpondeurs ayant leur propre source d'alimentation, par exemple une pile, mais devant également fonctionner sans, soit pour certaines applications, soit en cas de défaillance de la source d'énergie. Le transpondeur peut être intégré dans un support tel qu'une étiquette (« tag » en anglais) ou une carte.

On englobe ainsi aussi bien le cas de modulation de phase d'un signal de porteuse avec un temps de symbole $T_s$ fixe, que le cas d'un temps de symbole $T_s$ variable, défini par exemple par le nombre de cycles par symbole.

La durée d'un symbole ou le temps de symbole $T_s$ est supérieur ou égal à deux cycles de signal de porteuse, par exemple égal à trois, quatre ou huit cycles de porteuse (ici, le signal de porteuse a une fréquence $f_c$ = 13,56 MHz pour simplifier la compatibilité avec l'existant, notamment la norme ISO 14443.

L'idée générale de la présente invention consiste à limiter le plus possible l'effet non désiré des sauts de phase entre deux symboles tout en permettant un débit de données élevé. Ceci peut être réalisé en étalant un saut de phase d'un symbole par rapport à un symbole précédent sur une première partie du temps de symbole, l'établissement du saut de phase étant achevé lors de la première partie du temps de symbole et les périodes des cycles étant constantes durant la deuxième partie du temps de symbole, en particulier pour permettre la démodulation et le décodage du signal.

En revenant vers la figure 1 précédemment décrite pour sa partie concernant l'état de la technique, on s'intéresse maintenant à la partie inférieure référencée par la flèche 10 représentant à titre d'exemple une transition selon l'invention.

Comme on le voit sur cette figure, à la transition du symbole n-1 vers le symbole n, pour la première partie 11 du symbole n, les trois premier niveaux bas 12 du symbole n sont rallongées de -$\pi$/4 de sorte que seulement le quatrième front montant 14 est déphasé de -3$\pi$/4 par rapport aux fronts du symbole n-1 précédent. Il en découle que la « fréquence » de cette période du symbole est diminuée, ici par exemple 0.875 f. On note donc que l'établissement du saut de phase est achevé lors de la première partie 11 du temps de symbole

Durant la deuxième partie 13 du symbole n, le saut de phase total - 3$\pi$/4 est alors établi, et permet la démodulation et le décodage du signal. On note que les périodes des cycles sont constantes durant la deuxième partie du temps de symbole.

On comprend donc que l'on étale ici un saut de phase important d'un symbole par rapport à un symbole précédent par portions de sauts de phase sur des cycles de porteuse successives.

Ceci est illustré à titre d'exemple sur le diagramme de constellation de la figure 2 montrant d'une part quatre états de phase $\pi$/2, $\pi$/4, 0, et -$\pi$/4 et d'autre part par des flèches 15 des règles pour passer d'un état de phase à un autre.

Ainsi, si le saut de phase est de $\pm$ $\pi$/4, le saut de phase est opéré directement sur le premier cycle de porteuse du symbole suivant.

Cependant, lorsque le saut de phase entre deux symboles consécutifs est supérieur à un seuil prédéfini, par exemple supérieur à $\pi$/4, on applique dans la première partie 11 du symbole sur au moins deux cycles de porteuse du symbole à transmettre une portion de saut de phase, par exemple des sauts de phase de $\pi$/4, la somme des portions de saut de phase étant égale au saut de phase entre les deux symboles consécutifs.

Sur ce diagramme, on voit que pour passer de l'état de phase 0 à $\pi$/2, on passe par deux sauts successifs de +$\pi$/4.

Et pour passer de $\pi$/2 à - $\pi$/4, on passe par trois sauts successifs de - $\pi$/4 (3*(- $\pi$/4) = - 3 $\pi$/4).

Il s'est avéré judicieux que le seuil de saut de phase entre deux symboles consécutifs qui déclenche le fait de passer par portions de saut de phases soit de $\pi$/4.

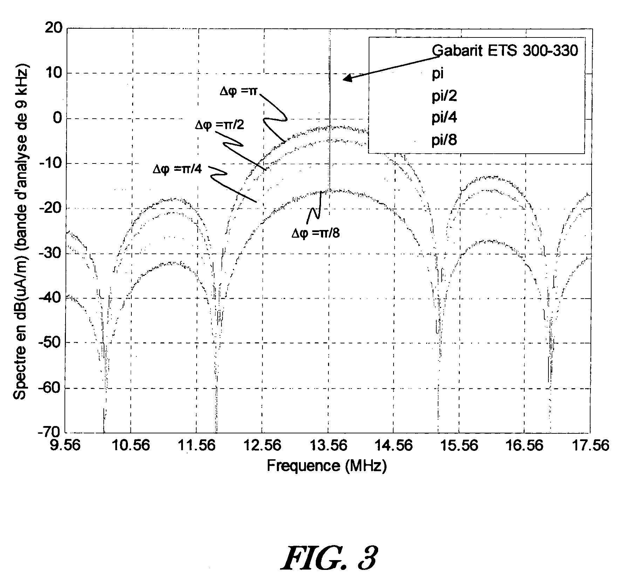

Comme on le voit sur la figure 3 montrant le spectre d'émission électromagnétique induit par des sauts de phase de $\pi$, $\pi$/2, $\pi$/4, et $\pi$/8 ainsi que le gabarit de la recommandation ETS 300-330, en procédant par portions de sauts de phase inférieures ou égale à $\pi$/4 (par exemple aussi $\pi$/8), on satisfait les contraintes stipulées par ces recommandations.

Comme cela a été montré ci-dessus, les portions de saut de phase sont toutes de même valeur de $\pm$ $\pi$/4.

Afin que le saut de phase total entre deux symboles soit établi le plus rapidement possible, on applique les portions de saut de phase successivement sur les premiers cycles de porteuse du symbole à transmettre.

Il s'est avéré judicieux que la première partie 11 du symbole pendant laquelle on peut appliquer les portions de saut de phase, possède une durée inférieure ou égale à 75% du temps de symbole.

Par exemple si le symbole possède une durée de 8*$T_c$, on applique les portions de saut de phase lors des six premiers cycles de manière que le saut de phase total entre deux symboles soit établi pendant les deux derniers cycles.

Dans le cas où on a par exemple huit états de phase, $\pi$/2, 3$\pi$/8, $\pi$/4, $\pi$/8, 0, - $\pi$/8, -$\pi$/4 et - 3$\pi$/8, pour passer d'un état de $\pi$/2 à 3$\pi$/8, on peut appliquer sur le premier cycle de porteuse du symbole une première portion de saut de phase de -$\pi$/4, puis sur les cinq cycles suivants des portions de sauts de phase de - $\pi$/8, le saut total de phase étant de -7 $\pi$/8.

Pour permettre de respecter plus facilement les recommandations européennes, on préfère que dans le schéma de modulation, le saut total maximal de phase entre deux symboles consécutifs soit strictement inférieur à $\pi$.

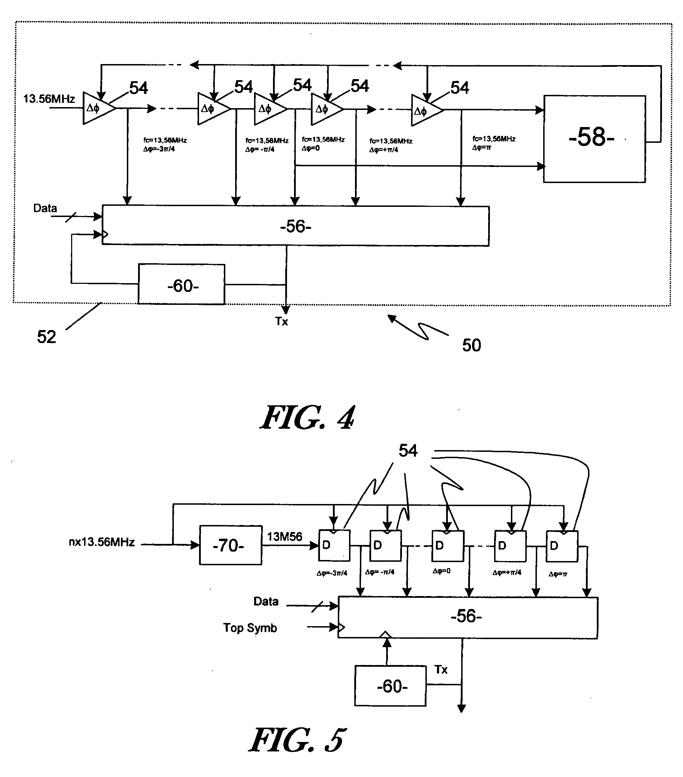

La figure 4 montre un schéma simplifié d'un dispositif 50 de modulation de phase d'un émetteur vers un transpondeur sans contact selon un premier mode de réalisation pour la mise en oeuvre d'un procédé tel que décrit ci-dessus.

Ce dispositif 50 comprend des moyens 52 de codage des données sous forme de symboles consécutifs ayant un nombre de cycles de porteuse prédéfinis, la durée d'un symbole étant supérieur ou égal à deux cycles de porteuse.

Ces moyens de codage 52 sont configurés de manière à étaler un saut de phase entre deux symboles consécutifs sur une première partie du symbole, l'établissement du saut de phase étant achevé lors de la première partie du temps de symbole et les périodes des cycles étant constantes durant la deuxième partie du temps de symbole

Plus en détail, ces moyens 52 comportent des cellules de déphasage 54.

Un signal de porteuse de fréquence f = 13,56 MHz est connecté à une entrée d'une première cellule de déphasage 54 déphasant la porteuse d'une valeur $\Delta\varphi = T_c/n$ (où n est le nombre de cellules de déphasage). Pour obtenir des déphasages positifs et négatifs, on place par convention la référence de phase au milieu de la chaine des déphaseurs.

Dans le cas où n = 8, la 1$^{ère}$ cellule délivre une porteuse à l'état de phase $-3\pi/4$. Chaque cellule de déphasage est connectée d'une part à une entrée d'un multiplexeur 56 et d'autre part à une entrée d'une autre cellule de déphasage 54.

Comme on voit sur la figure 4, on a ainsi une suite de cellules de déphasage 54 délivrant à des entrées associées du multiplexeur 56 des porteuses correspondant aux divers états de phase en accord avec le diagramme de constellation choisi, par exemple celui de la figure 2. On couvre donc l'ensemble de la gamme des états de phase.

Un comparateur de phase 58 reçoit en entrée un signal de porteuse de référence considérée comme non déphasée ainsi qu'un signal de porteuse déphasée de $\pi$ et délivre son signal de sortie aux entrées de commande des cellules de déphasage 54.

Le multiplexer 56 comprend en outre une entrée de données et une unité de contrôle de multiplexage 60 recevant en entrée la sortie de transmission du multiplexeur 56 et délivrant un signal de contrôle à une entrée correspondante de ce multiplexer 56. Cette unité de contrôle 60 sélectionne l'entrée de porteuse du multiplexer 56 qui est transmise vers la sortie de transmission Tx.

Ainsi, lorsque le saut de phase entre deux symboles consécutifs à transmettre est supérieur à un seuil prédéfini, par exemple de $\pi//4$, l'unité de contrôle 60 bascule progressivement de la porteuse transmise avec le symbole précédent vers la porteuse à atteindre en passant par des états de phase intermédiaires dans une première portion 11 du symbole.

La configuration de la figure 4 montre un exemple où la portion de saut de phase est égale à $\pi/4$, mais on peut également choisir qu'elle soit inférieure à $\pi/4$, par exemple $\pi/8$.

Les moyens de codage 52 sont configurés de manière à appliquer les portions de saut de phase successivement sur les premiers fronts du symbole à transmettre.

La figure 5 montre une variante du dispositif de modulation de la figure 4.

Cette variante se différencie du dispositif de la figure 4 par le fait que l'on recrée la porteuse à partir d'un signal de fréquence $n*f_c$ (où n est le nombre de cellules de déphasage) à l'aide d'un diviseur 70, puis comme précédemment, la porteuse est successivement déphasée de façon logique par des bascules D formant une cellules de déphasage 54 d'une valeur $\Delta\varphi = T_c/n$.

Selon un autre mode de réalisation, du procédé selon l'invention, appelé « mode analogique », on étale le saut de phase pas de manière discrète par portions de saut de phase $\Delta\varphi$ comme décrit précédemment, mais de manière continue, signal et sa dérivé, sur la première partie 11 du symbole, l'établissement du saut de phase étant achevé lors de la première partie 11 du temps de symbole et les périodes des cycles étant constantes durant la deuxième partie 13 du temps de symbole. On parle alors de glissement de phase.

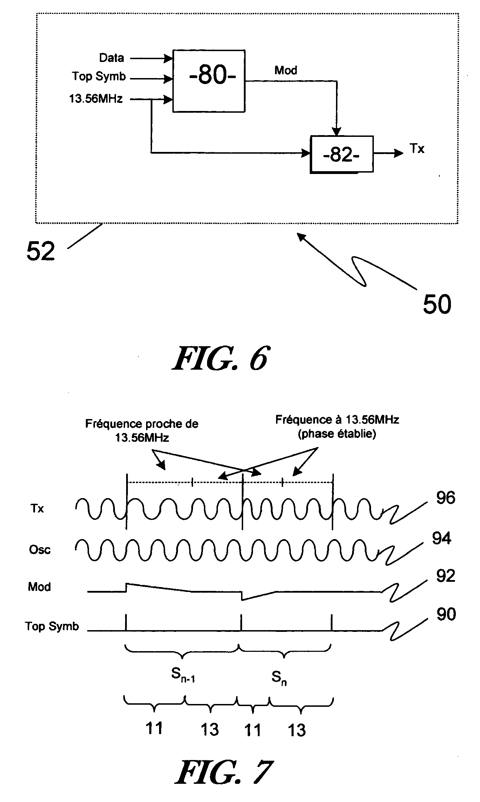

Ce mode de réalisation peut être mis en oeuvre par un dispositif de modulation de phase tel que représenté sur la figure 6.

Dans ce cas les moyens de codage de données 52 comprennent un module 80 de glissement de phase par variation de la fréquence de porteuse pendant la première partie du temps de symbole.

Ce module 80 reçoit en entrée les données (« Data »), un signal de début de symbole (« Top Symb ») et un signal de porteuse, par exemple à 13,56MHz.

Ce signal de porteuse ainsi que le signal de sortie Mod du module 80 sont délivrés à des entrées d'un modulateur de fréquence 82 qui délivre à sa sortie le signal Tx à transmettre.

La figure 7 montre un diagramme chronologique de deux symboles consécutifs $S_{n-1}$ et $S_n$ permettant d'expliquer le fonctionnement du dispositif de la figure 6.

La première ligne 90 montre les signaux de synchronisation de début de symbole (« Top Symb »), la deuxième ligne 92 montre le signal de sortie du module 80.

La troisième ligne 94 montre le signal de porteuse OSC en entrée du modulateur de fréquence 82 et la quatrième ligne 96 la sortie Tx du modulateur de fréquence 82.

On distingue sur la ligne Mod pour chacun des deux symboles $S_{n-t}$ et $S_n$ une première partie 11 en forme de rampe, montante ou descendante en fonction du saut de phase total à atteindre, rampe représentant la variation de la fréquence de la porteuse pour atteindre l'état de phase final lors de la deuxième partie 13 du temps de symbole.

On comprend donc que l'invention permet de maintenir d'une part la téléalimenation et d'autre part la fourniture de l'horloge, tout en permettant un débit de données optimisé.

## Revendications

1. Procédé de modulation de phase d'un signal de porteuse d'un émetteur vers un transpondeur sans contact, dans lequel on code des données sous forme de symboles consécutifs (Sn-1, Sn) correspondant chacun à un nombre prédéfini de cycles de porteuse, et ayant un temps de symbole (Ts) supérieur ou égal à deux cycles du signal de porteuse, dans lequel on étale au niveau de l'émetteur un saut de phase d'un symbole par rapport à un symbole précédent sur une première partie (11) du temps de symbole, l'établissement du saut de phase étant achevé lors de la première partie (11) du temps de symbole et les périodes des cycles étant constantes durant la deuxième partie du temps de symbole, **caractérisé en ce que** lorsque le saut de phase entre deux symboles consécutifs à transmettre est supérieur à un seuil prédéfini, on applique dans une première partie (11) du temps de symbole sur au moins deux cycles de porteuse du symbole à transmettre une portion de saut de phase, la somme des portions de saut de phase étant égale au saut de phase entre les deux symboles consécutifs.

2. Procédé de modulation de phase selon la revendication 1, **caractérisé en ce que** la modulation de phase comprend au moins quatre états de phase, notamment quatre ou huit états de phase.

3. Procédé de modulation de phase selon la revendication 1 ou 2, **caractérisé en ce qu'**une portion de saut de phase est inférieure ou égale à $\pi/4$.

4. Procédé de modulation de phase selon l'une quelconque des revendications 1 à 3, **caractérisé en ce que** les portions de saut de phase sont appliquées successivement sur les premières cycles de porteuse du symbole à transmettre.

5. Procédé de modulation de phase selon l'une quelconque des revendications 1 à 4, **caractérisé en ce que** la première partie (11) du temps de symbole (Ts), possède une durée inférieure ou égale à 75% du temps de symbole (Ts).

6. Dispositif (50) de modulation de phase d'un signal de porteuse d'un émetteur vers un transpondeur sans contact, comprenant des moyens de codage des données (52) sous forme de symboles consécutifs (Sn-1, Sn) correspondant chacun à un nombre prédéfini de cycles de porteuse, et ayant un temps de symbole (Ts) supérieur ou égal à deux cycles du signal de porteuse,
dans lequel lesdits moyens de codage des données (52) sont configurés de façon à appliquer un saut de phase entre deux symboles consécutifs (Sn-1, Sn) en étalant au niveau de l'émetteur un saut de phase d'un symbole par rapport à un symbole précédent sur une première partie (11) du temps de symbole, l'établissement du saut de phase étant achevé lors de la première partie (11) du temps de symbole et les périodes des cycles étant constantes durant la deuxième partie du temps de symbole, **caractérisé en ce que** les moyens de codage des données (52) sont configurés pour appliquer sur au moins deux cycles de porteuse du symbole à transmettre une portion de saut de phase, lorsque le saut de phase entre deux symboles consécutifs à transmettre est supérieur à un seuil prédéfini, la somme des portions de saut de phase étant égale au saut de phase entre les deux symboles consécutifs.

7. Dispositif de modulation de phase selon la revendication 6, **caractérisé en ce que** la modulation de phase comprend au moins quatre états de phase, notamment quatre ou huit états de phase.

8. Dispositif de modulation de phase selon la revendication 6 ou 7, **caractérisé en ce qu'**une portion de saut de phase est inférieure ou égale à n/4.

9. Dispositif de modulation de phase selon l'une quelconque des revendications 6 à 8, **caractérisé en ce que** lesdits moyens de codage de données (52) sont configurés de manière à appliquer les portions de saut de phase successivement sur les premières cycles de porteuse du symbole à transmettre.

10. Dispositif de modulation de phase selon l'une quelconque des revendications 6 à 9, **caractérisé en ce que** lesdits moyens de codage de données (52) comprennent des cellules (54) d'application d'une portion d'un saut de phase à un signal de porteuse, de manière à couvrir l'ensemble de la gamme des états de phase, un multiplexeur (56) recevant en entrée les signaux de porteuse et les signaux de porteuses déphasées ainsi que les données à coder et une unité de contrôle (60) de multiplexage commandant le multiplexeur (56).

11. Dispositif de modulation de phase selon l'une quelconque des revendications 6 à 10, **caractérisé en ce que** la première partie (11) du temps de symbole (Ts), possède une durée inférieure ou égale à 75% du temps de symbole (Ts).

**Patentansprüche**

1. Verfahren zur Phasenmodulation eines Trägersignals eines Senders zu einem Transponder ohne Kontakt, wobei Daten in Form von aufeinanderfolgenden Symbolen (Sn-1, Sn) kodiert werden, die jeweils einer festgelegten Anzahl von Trägerzyklen entsprechen und eine Symbolzeit (Ts) größer oder gleich zwei Zyklen des Trägersignals aufweisen, wobei hinsichtlich des Senders ein Phasensprung eines Symbols in Bezug auf ein vorhergehendes Symbol über einen ersten Abschnitt (11) der Symbolzeit ausgebreitet wird, wobei das Erzeugen des Phasensprungs während des ersten Abschnitts (11) der Symbolzeit erreicht wird und die Zeitspannen der Zyklen während des zweiten Abschnitts der Symbolzeit konstant sind, **dadurch gekennzeichnet, dass**, wenn der Phasensprung zwischen zwei zu übertragenden aufeinanderfolgenden Symbolen größer als ein festgelegter Schwellenwert ist, in einem ersten Abschnitt (11) der Symbolzeit für mindestens zwei Trägerzyklen des zu übertragenden Symbols ein Teil eines Phasensprungs angewendet wird, wobei die Summe der Teile eines Phasensprungs dem Phasensprung zwischen den zwei aufeinanderfolgenden Symbolen entspricht.

2. Verfahren zur Phasenmodulation nach Anspruch 1, **dadurch gekennzeichnet, dass** die Phasenmodulation mindestens vier Phasenzustände, besonders vier oder acht Phasenzustände umfasst.

3. Verfahren zur Phasenmodulation nach Anspruch 1 oder 2, **dadurch gekennzeichnet, dass** ein Teil eines Phasensprungs kleiner oder gleich $\pi/4$ ist.

4. Verfahren zur Phasenmodulation nach einem der Ansprüche 1 bis 3, **dadurch gekennzeichnet, dass** die Teile eines Phasensprungs aufeinanderfolgend für die ersten Trägerzyklen des zu übertragenden Symbols angewendet werden.

5. Verfahren zur Phasenmodulation nach einem der Ansprüche 1 bis 4, **dadurch gekennzeichnet, dass** der erste Abschnitt (11) der Symbolzeit (Ts) eine Dauer aufweist, die kleiner oder gleich 75 % der Symbolzeit (Ts) ist.

6. Vorrichtung (50) zur Phasenmodulation eines Trägersignals eines Senders zu einem Transponder ohne Kontakt, umfassend Datenkodierungsmittel (52) in Form von aufeinanderfolgenden Symbolen (Sn-1, Sn), die jeweils einer festgelegten Anzahl von Trägerzyklen entsprechen und eine Symbolzeit (Ts) größer oder gleich zwei Zyklen des Trägersignals aufweisen,
wobei die Datenkodierungsmittel (52) so konfiguriert sind, dass sie zwischen zwei aufeinanderfolgenden Symbolen (Sn-1, Sn) einen Phasensprung anwenden, indem sie hinsichtlich des Senders einen Phasensprung eines Symbols in Bezug auf ein vorhergehendes Symbol über einen ersten Abschnitt (11) der Symbolzeit ausbreiten, wobei das Erzeugen des Phasensprungs während des ersten Abschnitts (11) der Symbolzeit erreicht wird und die Zeitspannen der Zyklen während des zweiten Abschnitts der Symbolzeit konstant sind, **dadurch gekennzeichnet, dass** die Datenkodierungsmittel (52) konfiguriert sind, um für mindestens zwei Trägerzyklen des zu übertragenden Symbols einen Teil des Phasensprungs anzuwenden, wenn der Phasensprung zwischen zwei zu übertragenden aufeinanderfolgenden Symbolen größer als ein festgelegter Schwellenwert ist, wobei die Summe der Teile eines Phasensprungs dem Phasensprung zwischen den zwei aufeinanderfolgenden Symbolen entspricht.

7. Vorrichtung zur Phasenmodulation nach Anspruch 6, **dadurch gekennzeichnet, dass** die Phasenmodulation mindestens vier Phasenzustände, besonders vier oder acht Phasenzustände umfasst.

8. Vorrichtung zur Phasenmodulation nach Anspruch 6 oder 7, **dadurch gekennzeichnet, dass** ein Teil eines Phasensprungs kleiner oder gleich $\pi/4$ ist.

9. Vorrichtung zur Phasenmodulation nach einem der Ansprüche 6 bis 8, **dadurch gekennzeichnet, dass** die Datenkodierungsmittel (52) so konfiguriert sind, dass sie die Teile eines Phasensprungs aufeinanderfolgend für die ersten Trägerzyklen des zu übertragenden Symbols anwenden.

**10.** Vorrichtung zur Phasenmodulation nach einem der Ansprüche 6 bis 9, **dadurch gekennzeichnet, dass** die Datenkodierungsmittel (52) Zellen (54) zur Anwendung eines Teils eines Phasensprungs für ein Trägersignal, um die gesamte Palette der Phasenzustände abzudecken, einen Multiplexer (56), der an seinem Eingang die Trägersignale und die phasenverschobenen Trägersignale sowie die zu kodierenden Daten empfängt und eine Multiplex-Steuereinheit (60) umfassen, die den Multiplexer (56) steuert.

**11.** Vorrichtung zur Phasenmodulation nach einem der Ansprüche 6 bis 10, **dadurch gekennzeichnet, dass** der erste Abschnitt (11) der Symbolzeit (Ts) eine Dauer aufweist, die kleiner oder gleich 75 % der Symbolzeit (Ts) ist.

**Claims**

**1.** Method of modulating the phase of a carrier wave signal from a transmitter to a contactless transponder, wherein data are encoded in the form of consecutive symbols (Sn-1, Sn), each corresponding to a predefined number of carrier wave cycles and having a symbol time (Ts) greater than or equal to two cycles of the carrier wave signal, wherein, at transmitter level, a phase shift of a symbol is spread in relation to a preceding symbol over a first part (11) of the symbol time, the establishment of the phase shift being completed during the first part (11) of the symbol time and the periods of the cycles being constant during the second part of the symbol time, **characterised in that** when the phase shift between two consecutive symbols to transmit is above a predefined threshold, a phase shift portion is applied in the first part (11) of the symbol time over at least two carrier wave cycles of the symbol to transmit, the sum of the phase shift portions being equal to the phase shift between the two consecutive symbols.

**2.** Phase modulation method according to Claim 1, **characterised in that** the phase modulation includes at least four phase states, in particular four or eight phase states.

**3.** Phase modulation method according to Claim 1 or 2, **characterised in that** a phase shift portion is less than or equal to $\pi/4$.

**4.** Phase modulation method according to any one of Claims 1 to 3, **characterised in that** the phase shift portions are applied successively over the first carrier wave cycles of the symbol to transmit.

**5.** Phase modulation method according to any one of Claims 1 to 4, **characterised in that** the first part (11) of the symbol time (Ts) has a duration less than or equal to 75% of the symbol time (Ts).

**6.** Device (50) for modulating the phase of a carrier wave signal from a transmitter to a contactless transponder, including means of encoding the data (52) in the form of consecutive symbols (Sn-1, Sn), each corresponding to a predefined number of carrier wave cycles and having a symbol time (Ts) greater than or equal to two cycles of the carrier wave signal, wherein said means of encoding the data (52) are configured so as to apply a phase shift between two consecutive symbols (Sn-1, Sn) by spreading, at transmitter level, a phase shift of a symbol in relation to a preceding symbol over a first part (11) of the symbol time, the establishment of the phase shift being completed during the first part (11) of the symbol time and the periods of the cycles being constant during the second part of the symbol time, **characterised in that** the means of encoding the data (52) are configured to apply a phase shift portion over at least two carrier wave cycles of the symbol to transmit when the phase shift between two consecutive symbols to transmit is above a predefined threshold, the sum of the phase shift portions being equal to the phase shift between the two consecutive symbols

**7.** Phase modulation device according to Claim 6, **characterised in that** the phase modulation includes at least four phase states, in particular four or eight phase states.

**8.** Phase modulation device according to Claim 6 or 7, **characterised in that** a phase shift portion is less than or equal to $\pi/4$.

**9.** Phase modulation device according to any one of Claims 6 to 8, **characterised in that** said means of encoding data (52) are configured so as to apply the phase shift portions successively over the first carrier wave cycles of the symbol to transmit.

**10.** Phase modulation device according to any one of Claims 6 to 9, **characterised in that** said means of encoding data (52) include cells (54) for applying a portion of a phase shift to a carrier wave signal so as to cover the entire range of phase states, the input of a multiplexer (56) receiving the carrier wave signals and the shifted carrier wave signals, together with the data to encode and a multiplexing control unit (60) controlling the multiplexer (56).

11. Phase modulation device according to any one of Claims 6 to 10, **characterised in that** the first part (11) of the symbol time (Ts) has a duration less than or equal to 75% of the symbol time (Ts).

FIG. 1

FIG. 2

*FIG. 3*

**FIG. 4**

**FIG. 5**

Data ⟶

Top Symb ⟶    **-80-**    Mod

13.56MHz ⟶

**-82-** ⟶ Tx

**52**

**50**

## FIG. 6

Fréquence proche de 13.56MHz

Fréquence à 13.56MHz (phase établie)

Tx     96

Osc     94

Mod     92

Top Symb     90

$S_{n-1}$      $S_n$

11    13    11    13

## FIG. 7

**EP 2 586 166 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 9741671 A